# EUROPÄISCHE PATENTSCHRIFT

(11) **EP 3 111 191 B1**
(45) Veröffentlichungstag und Bekanntmachung des Hinweises auf die Patenterteilung: **19.07.2017**
(21) Anmeldenummer: 15777886.1
(22) Anmeldetag: 18.09.2015
(51) Int. Cl.: G01N 13/00

(54) **VERFAHREN UND VORRICHTUNG ZUR BESTIMMUNG EINER BARRIEREWIRKUNG EINER BESCHICHTUNG AUF EINEM SUBSTRAT**
METHOD AND DEVICE FOR DETERMINING A BARRIER EFFECT OF A COATING ON A SUBSTRATE
PROCÉDÉ ET DISPOSITIF DE DÉTERMINATION D'UN EFFET BARRIÈRE D'UN REVÊTEMENT SUR UN SUBSTRAT

(30) Priorität: 26.09.2014 DE 102014219496
(43) Veröffentlichungstag der Anmeldung: 04.01.2017
(73) Patentinhaber: Carl Zeiss Vision International GmbH, 73430 Aalen (DE)
(72) Erfinder: NEUFFER, Andreas, 71679 Asperg (DE)
(74) Vertreter: Carl Zeiss AG - Patentabteilung
(86) Internationale Anmeldenummer: PCT/EP2015/071474
(87) Internationale Veröffentlichungsnummer: WO 2016/046085

(56) Entgegenhaltungen:
- DE-B3-102013 104 846
- DE-C1- 19 519 975
- DE-T2- 69 509 776

## Beschreibung

Die Erfindung betrifft ein Verfahren zur Bestimmung einer Barrierewirkung einer Beschichtung auf einem Substrat nach dem Oberbegriff des Patentanspruchs 1 sowie eine Vorrichtung zur Bestimmung einer Barrierewirkung einer Beschichtung auf einem Substrat nach dem Oberbegriff des Patentanspruchs 14.

In der Materialwissenschaft versteht man unter einem Substrat ein zu behandelndes Material. Häufig wird die Oberfläche des Substrats veredelt oder beschichtet. Im Rahmen der vorliegenden Patentanmeldung umfasst das Substrat den Körper, der eine Beschichtung trägt, deren Barrierewirkung bestimmt werden soll. Das Substrat kann demnach insbesondere aus einem Grundkörper aus einem einheitlichen Material bestehen, auf den bereits eine Beschichtung aufgebracht ist, die aber selbst nicht Gegenstand der Untersuchung auf deren Barrierewirkung sein soll.

Unter Beschichten (englisch coating) wird in der Fertigungstechnik eine Hauptgruppe der Fertigungsverfahren nach DIN 8580 verstanden, die zum Aufbringen einer festhaftenden Schicht aus formlosem Stoff auf die Oberfläche eines Werkstückes genutzt werden. Der entsprechende Vorgang sowie die aufgetragene Schicht selbst werden als Beschichtung bezeichnet. Bei einer Beschichtung kann es sich um eine dünne Schicht oder eine dicke Schicht sowie um mehrere in sich zusammenhängende Schichten handeln. Die Beschichtungsverfahren unterscheiden sich durch die Art der Schichtaufbringung in chemische, mechanische, thermische und thermomechanische Verfahren.

Unter Barriere versteht man im Rahmen der vorliegenden Patentanmeldung ein Hindernis. Eine Barrierewirkung einer Beschichtung ist demnach ein Maß für die Wirkung der Beschichtung als Hindernis für ein Medium. Ein derartiges Medium kann ein Fluid, also ein Gas oder eine Flüssigkeit, sein.

Die Erfindung betrifft ein Verfahren, mit dessen Hilfe die Barriereeigenschaften von Schichten, insbesondere aufgedampften Schichten (z.B. mittels physikalischer Gasphasenabscheidung bzw. physical vapor deposition PVD, aufgebrachten Schichten), chemisch reaktiv abgeschiedenen Schichten (z.B. mittels plasma enhanced chemical vapor deposition PECVD oder plasma induced chemical vapor deposition PICVD), durch Kathodenzerstäubung bzw. Sputtern aufgebrachten Schichten, galvanisch abgeschiedenen Schichten oder Lackschichten auf einem geeigneten Substrat gemessen und quantitativ beurteilt werden kann.

Aus der DE 100 12 446 A1 ist ein Verfahren zum Messen der Gasdurchlässigkeit einer Beschichtung auf einer Kunsstoffwandung bekannt. In der US 8,266,944 B2 ist ein Verfahren zur Bewertung der Kratzfestigkeit eines Kunststoffharzes beschrieben.

Speziell im Bereich von Kunststoffbeschichtungen, insbesondere auf dem Gebiet der Beschichtung von Brillengläsern aus Kunststoff mit Entspiegelungsschichten, ist bekannt, dass unter Einwirkung von Feuchtigkeit die Kunststoffe diese Feuchtigkeit aus der Umgebung aufnehmen können und damit ihr Volumen vergrößern. Dies führt, sofern auf dem Kunststoff eine nicht feuchtigkeitstransparente Beschichtung vorhanden ist, zu lokalen Quellungen, die als sogenannte Verwerfungen die Oberfläche des mit der Beschichtung versehenen (vergüteten) Kunststoffes so verzerren, dass dies als optische Störung wahrgenommen werden kann.

Zur Messung von Barriereeigenschaften an solchen Kunststoff/Beschichtungs-Systemen gegenüber Feuchtigkeit ist aus dem betriebsinternen Stand der Technik und aus der DE 10 2013 104 846 B3 ein Verfahren bekannt, das mittels Infrarotabsorption den Wassergehalt im Kunststoffsubstrat misst, um dann rechnerisch den Transmissionsgrad von Wasser durch das auf dem Kunststoff sich befindende Schichtsystem zu ermitteln. Diese Infrarot-Messtechnik ist jedoch bezüglich der durch das eindringende Wasser entstehenden Verwerfungen nur eine indirekte Methode, die über das Quellverhalten des Kunststoffes keine Aussage treffen kann.

Die Aufgabe der Erfindung besteht daher darin, ein Verfahren und eine Vorrichtung bereitzustellen, mit deren Hilfe Aussagen über die Barriereeigenschaften einer auf einem Substrat, insbesondere einem Kunststoff, aufgebrachten Beschichtung und das Quellverhalten des Substrats, insbesondere Kunststoffes, zusammen mit der Beschichtung quantitativ gemacht werden können.

Diese Aufgabe wird durch ein Verfahren mit den Merkmalen des Patentanspruchs 1 sowie eine Vorrichtung mit den Merkmalen des Patentanspruchs 14 gelöst. Vorteilhafte Ausführungen und Weiterbildungen der Erfindung sind in den Unteransprüchen angegeben.

Das erfindungsgemäße Verfahren zur Bestimmung einer Barrierewirkung einer Beschichtung für ein Medium erfordert, dass sich die Beschichtung auf einer Oberfläche eines Substrats befindet, welches sein Volumen verändert, insbesondere vergrößert oder ggf. auch verkleinert, wenn es in Kontakt mit dem Medium gelangt. Das Verfahren zur Bestimmung einer Barrierewirkung einer Beschichtung für ein Medium umfasst die folgenden Schritte:
In einem Schritt a) erfolgt zunächst das Bereitstellen der Beschichtung auf einer Oberfläche eines Substrats, welches bei Kontakt mit dem Medium sein Volumen verändert, insbesondere vergrößert. Alternativ kann in dem Schritt a) auch ein Substrats mit der Beschichtung auf seiner Oberfläche bereitgestellt werden, welches bei Kontakt mit dem Medium sein Volumen verändert.

Das Substrat kann z.B. ein Brillenglasrohling aus einem Kunststoffmaterial sein. Für die Herstellung von Brillengläsern werden z.B. Kunststoffmaterialien mit den Handelsbezeichnungen MR 7, MR 8, MR 10 sowie CR 39, CR 607, CR 630 verwendet. Bei den Kunststoffmaterialien mit den Handelsbezeichnungen MR 7, MR 8 und MR 10 handelt es ich um Polythiourethane, die von der Firma Mitsui Chemicals vertrieben werden. Die Abkürzung "MR" steht dabei für Mitsui Resin. CR 39 oder Columbia Resin 39 ist die von der Firma Pittsburgh Plate Glass Industries (PPG Industries) gewählte Marke, unter der der Werkstoff Polydiethylenglycolbisallylcarbonat bzw. Polyallyldiglycolcarbonat (Abkürzung: PADC) vertrieben wird. Hierbei handelt es sich um einen höherbrechenden duroplastischen Polymerwerkstoff. CR 607 und CR 630 stammen ebenfalls von der Firma PPG. Die Materialien CR 607 und CR 630 werden z.B. für photochrome Anwendungen eingesetzt.

Das Substrat kann nicht nur in Form eines Volumenmaterials vorliegen. Es muss auch nicht materialeinheitlich ausgebildet sein. Vielmehr ist es möglich, dass das Substrat aus einem Grundmaterial besteht, das eine Beschichtung trägt. In Fortführung des vorstehend beschriebenen Beispiels kann das Substrat ein Brillenglasrohling sein, bestehend aus einem Kunststoffgrundkörper und einer Hartlackbeschichtung.

Das Medium kann z.B. Wasser in flüssiger Form oder als Wasserdampf, also gasförmig, sein. Insbesondere im vorstehend beschriebenen Fall der Untersuchung eines Brillenglasrohlings als Substrat kann auch die Untersuchung der Barrierewirkung gegenüber Fetten, Ölen sowie ätzenden Flüssigkeiten oder Dämpfen von Bedeutung sein.

Hauptanwendungsfall des erfindungsgemäßen Verfahrens ist die Untersuchung des Eindringverhaltens des Mediums nach vorhergehender Transmission durch die Beschichtung in das Substrat. Es eignet sich aber auch zur Untersuchung des durch das Medium induzierten Transmissionsverhaltens von Bestandteilen des Substrats (in die entgegengesetzte Richtung) durch die Beschichtung.

Im Falle des Brillenglasrohlings kann die Beschichtung eine Entspiegelungs- oder Antireflexionsbeschichtung sein. Die Beschichtung kann alternativ oder ggf. spektralselektiv zusätzlich auch eine Verspiegelungsbeschichtung sein. Die Beschichtung kann zusätzlich oder alternativ eine antistatisch wirkende Beschichtung sein. Die Beschichtung kann eine Kratzschutz- oder Hartbeschichtung sein. Die Beschichtung kann eine das Beschlagen mit Wasserdampf verhindernde oder zumindest vermindernde Beschichtung sein. Die Beschichtung kann eine photochrome, phototrope oder elektrochrome Funktionalität aufweisen.

In einem weiteren Schritt b) erfolgt ein Konditionieren des Substrats mit der Beschichtung. Unter Konditionierung sei im Rahmen der vorliegenden Erfindung die Behandlung des Substrats mit der Beschichtung mit dem Ziel einen definierten und/oder reproduzierbaren Ausgangszustand für die nachfolgenden Schritte zu schaffen bzw. bereitzustellen.

Unter Konditionierung versteht man insbesondere in der Kunststofftechnik das Lagern bis hin zum Gewichtsausgleich (Gewichtskonstanz) durch Wasseraufnahme bei Normklima (23 °C und 50 % Luftfeuchte). Der Prozess des Konditionierens ist hierbei reversibel.

Beim vorstehend beschriebenen Beispiel der Untersuchung eines Kunststoffbrillenglases in feuchter Umgebung muss nicht zwangsläufig das in der Kunststofftechnik übliche Lagern bei Normklima verwendet werden. Andere auf den Anwendungszweck abgestimmte klimatische Bedingungen kommen ebenfalls in Betracht.

In einem nachfolgenden Schritt c) erfolgt das Entfernen der Beschichtung von einer ersten Teiloberfläche des Substrats. Die Beschichtung verbleibt dabei auf einer zweiten Teiloberfläche des Substrats unverändert bestehen. Das Entfernen der Beschichtung muss nicht zwangsläufig vollständig, bis zur Oberfläche des Substrats hinunter erfolgen. In normaler Richtung zur Substratoberfläche kann durchaus ein Teil der Beschichtung bestehen bleiben. Die Ausdehnung der ersten Teiloberfläche ist dabei in eine erste Richtung durch die auf der zweiten Teiloberfläche verbliebene Beschichtung begrenzt. Die Funktion des Entfernens der Beschichtung besteht darin, einen vollständigen oder erleichterten Durchgang für das Medium, insbesondere Feuchtigkeit oder Wasser, zu schaffen, mit dem das System, z.B. Kunststoffbrillenglasrohling und Beschichtung, auf Barriereeigenschaften und Quellverhalten untersucht wird.

In einem Schritt d) erfolgt ein Bestimmen eines ersten Höhenprofils einer Oberfläche der Beschichtung auf der zweiten Teiloberfläche und der ersten Teiloberfläche des Substrats auf einem Weg längs der ersten Richtung.

Danach wird in einem Schritt e) die Oberfläche der verbleibenden Beschichtung und der ersten Teiloberfläche des Substrats dem Medium ausgesetzt. Bei dem zuvor beschriebenen Beispiel kann das Kunststoffsubstrat-Beschichtung-System in eine entsprechend feuchte Atmosphäre verbracht werden, z.B. in eine Klimakammer, bei der eine Temperatur von 40 °C und eine relative Luftfeuchtigkeit von 90 % herrscht, so dass ein Quellen stattfinden kann. Die Expositionsdauer, in dem das vorbereitete Substrat mit der Beschichtung dem Medium ausgesetzt ist, ist dabei vorzugsweise vorbestimmt, um möglichst definierte und damit vergleichbare Bedingungen zu schaffen.

In einem weiteren Schritt f) erfolgt ein Bestimmen eines zweiten Höhenprofils der Oberfläche der Beschichtung auf der zweiten Teiloberfläche und der ersten Teiloberfläche des Substrats auf dem Weg längs der ersten Richtung und/oder ein Bestimmen einer ersten Höhenprofildifferenz der Oberfläche der Beschichtung auf der zweiten Teiloberfläche und der ersten Teiloberfläche des Substrats auf dem Weg längs der ersten Richtung gegenüber dem zuvor bestimmten Höhenprofil. Damit wird eine Veränderung der Oberfläche erfasst und man erhält ein Maß für das Quellverhalten des Substrats und damit die Barrierewirkung der Beschichtung.

Die vorstehend angegebene Aufgabe wird demnach durch das erfindungsgemäße Verfahren vollumfänglich gelöst.

Es hat sich herausgestellt, dass sich das Entfernen der Beschichtung gemäß Schritt c) sehr schnell mit einem Ritzwerkzeug, insbesondere einem Diamantritzwerkzeug durchführen lässt, welches längs der ersten Richtung Material abtragend geführt wird. Ein Diamant hat einen definierten Spitzenradius und die Last lässt sich definiert einstellen. Die Reproduzierbarkeit des erfindungsgemäßen Verfahrens und die Vergleichbarkeit der Ergebnisse in quantitativer Hinsicht ist damit gewährleistet.

Das Entfernen der Beschichtung erfolgt insbesondere im Falle der vorstehend beschriebenen Untersuchung eines Brillenglasrohlings aus ggf. mit einem Hartlack beschichteten Kunststoff vorzugsweise mit Hilfe eines Ritzwerkzeugs mit einem Schneidendurchmesser im Nanometerbereich, einem sogenannten Nano-Scratcher. Dadurch ist auch im Falle eines Vergleichs unterschiedlich harter Schichten und/oder unterschiedlich poröser Schichten gewährleistet, dass sich die Abmessungen bzw. Ausdehnungen der Bereiche, in denen die Beschichtung entfernt wird nicht unterscheidet.

Experimente haben gezeigt, dass reproduzierbare Ergebnisse erreichbar sind, wenn die erste Teiloberfläche, in der die Beschichtung entfernt ist, eine langgestreckte Form aufweist. Die erste Teiloberfläche weist demnach die vorstehend beschriebene Ausdehnung in die erste Richtung und eine Ausdehnung in eine zweite Richtung auf. Die Ausdehnung der ersten Teiloberfläche in der ersten Richtung ist bevorzugt wenigstens zehnfach größer als die Ausdehnung der ersten Teiloberfläche in der zweiten Richtung. Oder anders ausgedrückt ist die Länge des Ritzes mindestens zehn mal so lang wie die Breite des Ritzes. Noch günstiger ist es, wenn die Ritzlänge zwischen zehn Mal und 100 Mal so groß wie die Ritzbreite ist.

Die mit dem Diamantwerkzeug aufgebrachte Last sollte im Falle des Brillenglasrohlings mit der Beschichtung so hoch sein, dass die zu untersuchende Beschichtung sicher aufbricht und die Spur auf der Beschichtung auch optisch zu sehen ist.

Um zu verhindern, dass das Medium durch andere Bereiche als die erste Teiloberfläche oder die mit der Beschichtung versehene Oberfläche in das Substrat eindringen kann, können diese anderen, nachfolgend als dritte Teiloberfläche bezeichneten Bereiche vorab mit einer für das Medium undurchlässigen Barriere versehen werden. Anders ausgedrückt kann vor dem Bestimmen des ersten Höhenprofils gemäß Schritt d) die nicht mit der ersten Teiloberfläche des Substrats identische, jedoch nicht mit der Beschichtung versehene dritte Teiloberfläche mit einer für das Medium undurchlässigen Barriere versehen werden.

Im Falle des vorstehend beschriebenen Beispiels Kunststoffbrillenglasrohling mit Beschichtung wird z.B. nach dem Aufbringen des Ritzes mit dem Diamantritzwerkzeug die unbeschichtete Rückseite des Brillenglasrohlings wasserdicht, z.B. mit einer Aluminiumfolie, abgeklebt.

Die Messapparatur, die zur Bestimmung eines Höhenprofils oder einer Höhenprofildifferenz in dem erfindungsgemäßen Verfahren verwendet werden kann, ist durch das Ausmaß des zu erwartenden Quellverhaltens des Substrats und die Ausdehnung des Bereichs bestimmt, in dem die Beschichtung entfernt wurde.

Beim Beispiel des Systems Brillenglasrohling/Beschichtung beträgt die Ritzlänge im allgemeinen wenige Millimeter und die zu erwartende Verwerfungshöhe liegt im zweistelligen bis vierstelligen Nanometerbereich. In einem derartigen Fall wird das Bestimmen des ersten Höhenprofils gemäß Schritt d) und/oder das Bestimmen des zweiten Höhenprofils und/oder der ersten Höhenprofildifferenz gemäß Schritt f) vorzugsweise mit Hilfe eines Interferometers durchgeführt. Das bevorzugte Interferometer besitzt eine Auflösung, mit der über die gesamte Ritzlänge die Höhe gemessen werden kann und zwar mindestens mit einer Auflösung von unter 10 nm.

Grundsätzlich ist es möglich, eine erste der oben genannten quantitativen Aussagen bereits nach der einmaligen Durchführung aller eingangs beschriebenen Verfahrensschritte zu erhalten. Es hat sich jedoch als günstig herausgestellt, wenn die Folge der Schritte e) und f) wiederholt durchgeführt wird. Damit erhält man eine quantitative Aussage über das zeitlich ablaufende Quellverhalten.

Weiter bevorzugt ist es, wenn die Folge der Schritte e) und f) so lange wiederholt durchgeführt wird, bis ein Abbruchkriterium erfüllt ist. Ein Abbruchkriterium kann z.B. dann erfüllt sein, wenn die Messreihe bis zu dem Zeitpunkt durchgeführt wird, bis nahezu keine Änderung an dem Quellverhalten des Substrats mehr festgestellt werden kann.

Letztere Bedingung kann z.B. dadurch zum Ausdruck gebracht werden, dass das Abbruchkriterium darin besteht, dass die erste Höhenprofildifferenz unter einem vorgegebenen Schwellwert liegt.

Wie oben bereits angedeutet, ist das Ausmaß des Entfernens der Beschichtung für die Anwendbarkeit des Verfahrens nicht ausschlaggebend ist. Wie zu erwarten, hat es sich aber als günstig herausgestellt, wenn das Entfernen der Beschichtung bei dem Schritt c) vollständig bis zur Oberfläche des Substrats durchgeführt wird, weil damit bei vergleichsweise geringem Aufwand eine reproduzierbare und vergleichbare Bedingung geschaffen werden kann.

Alternativ hat der Erfinder jedoch festgestellt, dass ein Verfahren, bei dem die Folge der Schritte c) bis f) mehrfach örtlich nebeneinander durchgeführt wird und das Entfernen der Beschichtung bei den jeweiligen Schritten c) bei den örtlich nebeneinander durchgeführten Folgen in unterschiedlichem Ausmaß durchgeführt wird, Vorteile hat. Mit diesem Verfahren kann nämlich eine Aussage über das Bruchlastverhalten der Beschichtung getroffen werden.

Bei letztgenanntem Verfahren ist es insbesondere günstig, wenn das Entfernen der Beschichtung in den jeweiligen Schritten c) bei den örtlich nebeneinander durchgeführten Folgen unter unterschiedlicher Last durchgeführt wird. Damit lässt sich die Ritztiefe variieren.

Wenn das Entfernen der Beschichtung bei wenigstens einem der jeweiligen Schritte c) bei den örtlich nebeneinander durchgeführten Folgen vollständig bis zur Oberfläche des Substrats durchgeführt wird, ist gewährleistet, dass ein das Medium in das Substrat eindringen und/oder mit dem Substrat in Kontakt treten kann und ein Aufquellen (oder ggf. Schrumpfen) stattfinden kann.

Wird das Entfernen der Beschichtung bei wenigstens einem der jeweiligen Schritte c) bei den örtlich nebeneinander durchgeführten Folgen nicht vollständig bis zur Oberfläche des Substrats durchgeführt, so kann durch Verbiegen des Substrats unter Last bei wenigstens einer der ursprünglich nicht bis zur Substratoberfläche hinunterreichenden Ritze ein vollständiger Schichtriss herbeigeführt werden, welcher einen direkten Kontakt zwischen Substrat und Medium erlaubt.

Das erfindungsgemäße Verfahren kann computergesteuert implementiert sein. Insbesondere umfasst die Erfindung ein Computerprogramm mit Programmcode zur Durchführung aller Verfahrensschritte nach einer der vorangehend beschriebenen Varianten, wenn das Computerprogramm in einem Computer geladen und/oder in einem Computer ausgeführt wird.

Die Erfindung betrifft auch eine Vorrichtung zur Bestimmung einer Barrierewirkung einer Beschichtung. Die Vorrichtung umfasst folgende Bestandteile:
Es ist eine Bereitstellungseinrichtung zum Bereitstellen der Beschichtung auf einer Oberfläche eines Substrats oder zum Bereitstellen eines Substrats mit der Beschichtung auf seiner Oberfläche vorhanden, welches bei Kontakt mit dem Medium sein Volumen vergrößert. Die Bereitstellungseinrichtung kann eine Auflagefläche umfassen, auf die eine Bedienperson das Substrat mit der Beschichtung abgelegt hat. Es kann auch eine Halteeinrichtung vorhanden sein, um das Substrat mit der Beschichtung lösbar in einer definierten Position zu halten, um die nachfolgenden Arbeitsschritte durchführen zu können.

Die erfindungsgemäße Vorrichtung umfasst eine Konditioniereinrichtung zum Konditionieren des Substrats mit der Beschichtung in der vorbeschriebenen Art und Weise. Die Konditioniereinrichtung kann aus einer Klimakammer bestehen oder eine solche umfassen, in der z.B. die relative Luftfeuchtigkeit, die Temperatur und die Expositionsdauer vorgegeben werden kann.

Es ist eine Entfernungseinrichtung zum Entfernen der Beschichtung von einer ersten Teiloberfläche des Substrats vorhanden, so dass die Beschichtung auf einer zweiten Teiloberfläche des Substrats verbleibt und so dass die erste Teiloberfläche eine durch die auf der zweiten Teiloberfläche verbliebene Beschichtung begrenzte Ausdehnung in eine erste Richtung aufweist. Wie oben beschrieben kann die Entfernungseinrichtung als Ritzwerkzeug, insbesondere als Diamantritzwerkzeug ausgebildet sein.

Weiterhin ist eine Bestimmungseinrichtung zum Bestimmen eines ersten Höhenprofils einer Oberfläche der Beschichtung auf der zweiten Teiloberfläche und der ersten Teiloberfläche des Substrats auf einem Weg längs der ersten Richtung vorgesehen. Bevorzugt umfasst diese Bestimmungseinrichtung ein Interferometer. Es ist günstig, wenn das Interferometer eine Auflösung von weniger als 10 nm besitzt.

Ferner ist eine Aussetzungseinrichtung zum Aussetzen der Oberfläche der verbleibenden Beschichtung und der ersten Teiloberfläche des Substrats dem Medium. Diese Aussetzungseinrichtung kann mit der vorstehend beschriebenen Konditioniereinrichtung identisch sein und insbesondere als Klimakammer mit den vorstehend beschriebenen Einstellmöglichkeiten ausgebildet sein.

Schließlich ist eine Bestimmungseinrichtung zum Bestimmen eines zweiten Höhenprofils der Oberfläche der Beschichtung auf der zweiten Teiloberfläche und der ersten Teiloberfläche des Substrats auf dem Weg längs der ersten Richtung und/oder zum Bestimmen einer ersten Höhenprofildifferenz der Oberfläche der Beschichtung auf der zweiten Teiloberfläche und der ersten Teiloberfläche des Substrats auf dem Weg längs der ersten Richtung gegenüber dem zuvor bestimmten Höhenprofil vorhanden. Dieses kann mit der Bestimmungseinrichtung zum Bestimmen des ersten Höhenprofils identisch sein. Insbesondere kann es als Interferometer mit einer Auflösung von unter 10 nm ausgebildet sein.

Es kann eine Transporteinrichtung vorhanden sein, die dazu eingerichtet ist, das Substrat mit der Beschichtung auf der Bereitstellungseinrichtung (z.B. Auflagefläche) zur Konditioniereinrichtung (z.B. Klimakammer), zur Entfernungseinrichtung (z.B. Ritzwerkzeug), zur Bestimmungseinrichtung (z.B. Interferometer), zur Aussetzungseinrichtung (z.B. Klimakammer), zur Bestimmungseinrichtung (z.B. Interferometer) entsprechend wenigstens einer der zuvor beschriebenen Verfahren zu transportieren. Die Vorrichtung umfasst z.B. eine Steuereinrichtung, um die Transporteinrichtung und ggf. die Funktionalität der übrigen Komponenten zu steuern.

Die Vorrichtung kann mit Hilfe eines Computers angesteuert werden. Zu diesem Zweck ist nach der Erfindung ein Computerprogramm mit Programmcode zur Durchführung aller Verfahrensschritte der eingangs beschriebenen Art in einer vorstehend beschriebenen Vorrichtung vorgesehen, wenn das Computerprogramm in dem Computer geladen und/oder in dem Computer ausgeführt wird, welcher die Vorrichtung steuert.

Die Erfindung wird nachfolgend anhand der Zeichnung näher beschrieben. Es zeigen:
- Figur 1: einen Ausschnitt eines Substrats bestehend aus einem mit einem Hartlack versehenen Kunststoffgrundkörper und einer auf dem Substrat befindlichen Entspiegelungsbeschichtung im Querschnitt,
- Figur 2: ein Entfernen der Entspiegelungsbeschichtung von einer ersten Teiloberfläche des Substrats mit Hilfe eines Diamantritzwerkzeugs in skizzenhafter Darstellung unter Verwendung des Ausschnitts nach der Figur 1,
- Figur 3: den Ausschnitt nach der Figur 1 nachdem das Diamantritzwerkzeug zum Entfernen der Entspiegelungsbeschichtung von der ersten Teiloberfläche des Substrats senkrecht zur Zeichnungsebene geführt wurde,
- Figur 4: eine Draufsicht auf einen Ausschnitt eines Brillenglasrohlings aus einem aus CR 39 bestehenden Kunststoffgrundkörper mit Hartlack und Entspiegelungsbeschichtung, welche mit einem Ritz entsprechend dem Schritt c) nach dem erfindungsgemäßen Verfahren versehen ist,
- Figur 5: ein mit einem Interferometer aufgenommenes zweidimensionales Höhenprofil des Ausschnitts nach der Figur 4 nach erfolgter Quellung des Substrats,
- Figur 6: einen Schnitt durch das Höhenprofil nach der Figur 5 in der Mitte des Ritzes,
- Figur 7a): eine feuchtwarme klimatische Exposition des Brillenglasrohlings nach der Figur 5 in einer skizzenhaften Darstellung entsprechend der Figur 1, wobei die Beschichtung keine Barriere für Feuchtigkeit darstellt
- Figur 7b): ein Höhenprofil der Oberfläche des Brillenglasrohlings senkrecht zum Ritz, gemessen nach der in der Figur 7a) dargestellten Exposition,
- Figur 8a): eine feuchtwarme klimatische Exposition des Brillenglasrohlings nach der Figur 5 in einer skizzenhaften Darstellung entsprechend der Figur 1, wobei die Beschichtung eine gewisse Barrierewirkung für Feuchtigkeit darstellt
- Figur 8b): ein Höhenprofil der Oberfläche des Brillenglasrohlings senkrecht zum Ritz, gemessen nach der in der Figur 8a) dargestellten Exposition nach Erreichen der Sättigung,
- Figur 9: eine zeitliche Abhängigkeit der Verwerfungshöhe H in Abhängigkeit von der Lagerungszeit t in feuchtwarmem Klima bei 40 °C und 95 % relativer Luftfeuchtigkeit (K1: Beschichtung stellt totale Barriere für Wasser dar; K2: Beschichtung stellt mittlere Barriere für Wasser dar; K3: Beschichtung stellt keine Barriere für Wasser dar),
- Figur 10: eine Matrix aus Ritzen entsprechend der Figur 4, die in die Oberfläche eines Brillenglasrohlings bei unterschiedlicher Last eingebracht worden sind,
- Figur 11: ein mit einem Interferometer aufgenommenes zweidimensionales Höhenprofil des Ausschnitts nach der Figur 10 nach erfolgter Exposition des Substrats einem feuchtwarmen Klima bei 40 °C und 95 % relativer Luftfeuchtigkeit,
- Figur 12: ein Ausführungsbeispiel einer erfindungsgemäßen Vorrichtung zur Bestimmung einer Barrierewirkung einer Beschichtung.

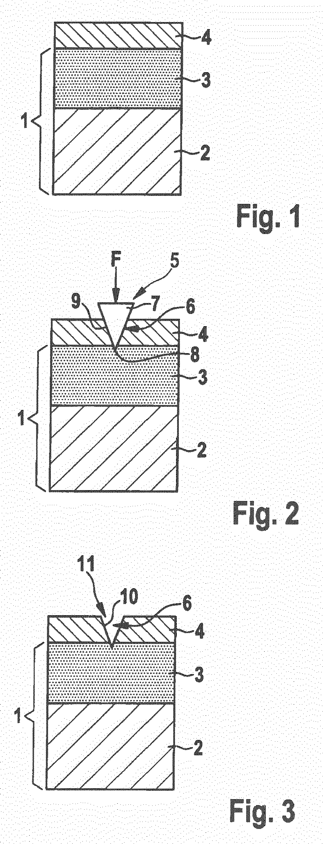

Die Figur 1 zeigt einen Ausschnitt eines Substrats 1 bestehend aus einem mit einem Hartlack 3 versehenen Kunststoffgrundkörper 2 und einer auf dem Substrat 1 befindlichen Entspiegelungsbeschichtung 4 im Querschnitt. Der Ausschnitt ist im vorliegenden Ausführungsbeispiel Bestandteil eines Brillenglasrohlings nach dem derzeitigen Stand der Technik. Es könnte sich grundsätzlich auch um den Ausschnitt eines Architekturglasfensters handeln.

Der Kunststoffgrundkörper 2 sei im vorliegenden Ausführungsbeispiel ein organischer Kunststoff wie Polyallyldiglycolcarbonat. Der Hartlack 3 besteht im allgemeinen aus einem nichtorganischen Kunststoff, wie beispielsweise Polysiloxanen mit ggf. hochbrechenden Komponenten, und die Entspiegelungs- bzw. Antireflexionsbeschichtung kann z.B. aus einer der in der DE 10 2010 048 088 A1 beschriebenen Schichtfolgen bestehen. Diese Brillenglasrohling wird entsprechend dem vorstehend beschriebenen Schritt a) bereitgestellt.

Die Bestimmung des Barriereverhaltens dieser auf dem Kunststoffsubstrat 1 bestehend aus organischem Kunststoffgrundkörper 2 und Hartlackbeschichtung 3 aufgebrachten Beschichtung 4 erfordert zunächst einige Tage vor der Durchführung von Messungen eine Exposition bzw. Lagerung in einem definierten Klima, z.B. bei Raumtemperatur und mittlerer Luftfeuchte von z.B. 50%, um einen konstant definierten Startpunkt für die nachfolgenden Messungen zu erhalten. Die Dauer der Exposition wird so gewählt, dass eine Änderung des Zustands des Systems Kunststoffsubstrat 1/Beschichtung 4 bei Fortdauer der Exposition nicht zu erwarten ist oder vernachlässigbar klein ist. Dieser Schritt wird auch als Konditionierung (vgl. Schritt b) oben) bezeichnet.

Anschließend wird mit einem Diamantritzwerkzeug 5, einem sogenannten Nano-Scratcher 5, ein Ritz 6 erzeugt, wie dies in der Figur 2 skizziert ist. Die Spitze 8 des Diamanten 7 weist einen bekannten Spitzenradius auf. Der Ritz 6 oder "Scratch 6" wird mit definierter Last F aufgebracht (vgl. Schritt c) oben). Üblicherweise beträgt die Last F im Falle des beschriebenen Systems 50 mN bei einem Spitzenradius von 2µm.

Die Figur 3 zeigt den Ausschnitt nach der Figur 1 nachdem das Diamantritzwerkzeug 5 zum Entfernen der Entspiegelungsbeschichtung 4 von der Oberfläche 11 des Substrats 1 senkrecht zur Zeichnungsebene geführt wurde. Die Querschnittskontur 10 des Ritzes 6 entspricht im Idealfall der Querschnittskontur 9 des Diamantritzwerkzeugs 5.

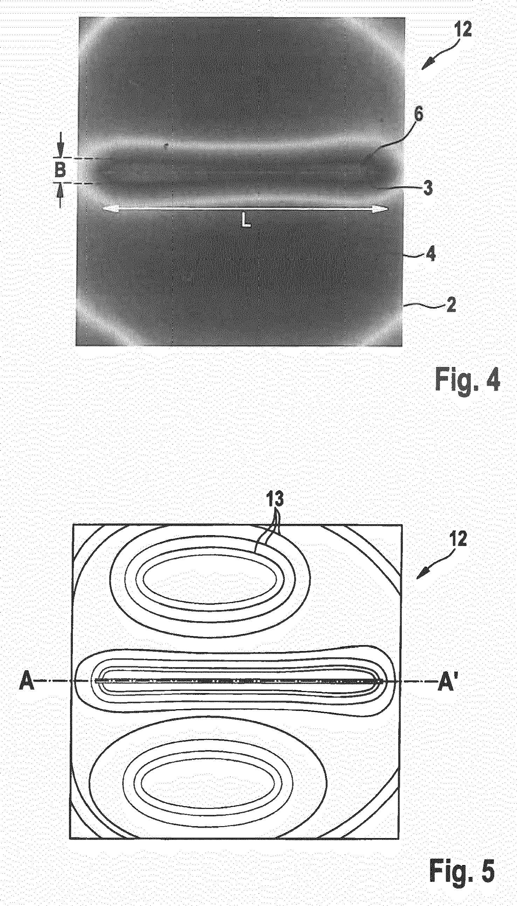

Die Figur 4 zeigt eine Draufsicht auf einen Ausschnitt eines Brillenglasrohlings 12 aus einem aus CR 39 bestehenden Kunststoffgrundkörper 2 mit Hartlack 3 und Entspiegelungsbeschichtung 4, welche mit einem Ritz 6 nach dem vorstehend beschriebenen Verfahrensschritt c) versehen wurde.

Die Länge L des "Scratches 6" sollte mindestens zehn mal so lang sein wie die Breite B des "Scratches 6", vorzugsweise jedoch zwischen zehn mal und 100 mal der Ritzbreite B betragen. Die Ritzlänge L beträgt im vorliegenden Ausführungsbeispiel 2,5 mm. Die Ritzbreite B beträgt 0,2 mm. Die in Figur 2 dargestellte Last F muss so hoch sein, dass die zu untersuchende Beschichtung 4 sicher aufbricht und die Spur bzw. der Verlauf des Ritzes 6 auf der Beschichtung 4 auch optisch zu sehen ist (Fig. 3 und 4).

Die Funktion des "Scratches 6" besteht darin, einen Durchgang für das Medium (vorzugsweise Feuchtigkeit bzw. Wasser) zu schaffen, mit dem das System bestehend aus Substrat 1 und Beschichtung 4 auf Barriereeigenschaften und Quellverhalten untersucht wird.

Nach dem Aufbringen des "Scratches 6" wird die Rückseite des Kunststoffsubstrates 2 wasserdicht abgeklebt, z.B. mit selbstklebender Aluminiumfolie. Dieser Schritt ist optional und dem Schritt d) vorgelagert. Bei vollständiger Oberflächenbeschichtung kann er per se entfallen. Grundsätzlich kann er auch vor dem Schritt c) oder ggf. auch vor dem Schritt b) erfolgen.

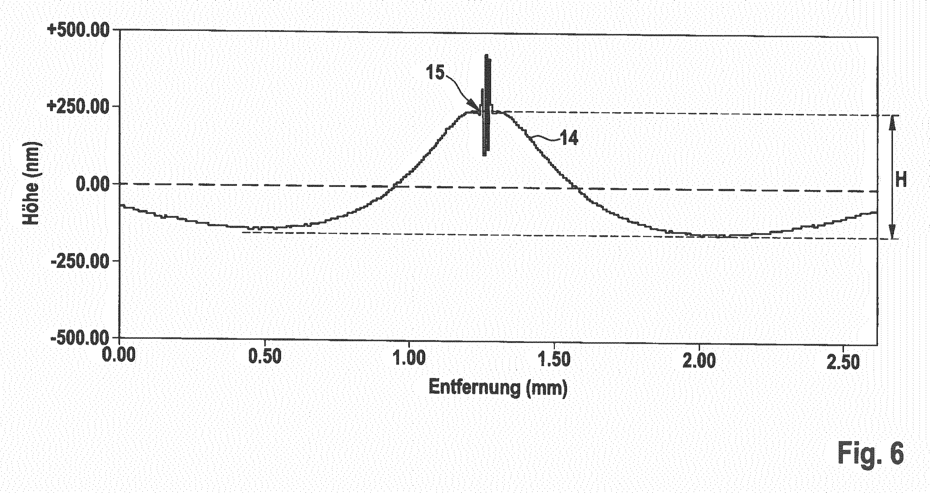

In dem Schritt f) erfolgt die Messung der Quell- oder Verwerfungshöhe mit Hilfe eines Interferometers, mit dem der gesamte Ritz 6 erfasst werden kann. Das Interferometer muss eine Auflösung besitzen, mit der über die gesamte Ritzlänge L die Höhe H gemessen werden kann und zwar im vorliegenden Beispielfall mindestens mit einer Auflösung von weniger als 10 nm. Die Figur 5 zeigt ein zweidimensionales Höhenprofil der Oberfläche des in der Figur 4 gezeigten Ausschnitts des Brillenglasrohlings 12. Es sind Höhenlinien 13 in 20 nm - Schritten eingezeichnet. Die Figur 6 zeigt das Höhenprofil 14 senkrecht zur Schnittlinie A - A' durch das Höhenprofil nach der Figur 5. Die Abszisse gibt die Entfernung in Millimeter an. Der Ordinate entnimmt man die Höhe in Nanometer bzgl. der nachfolgend beschriebenen Grundlinie.

Um die Quell- oder Verwerfungshöhe H, also die Höhendistanz zwischen dem Substratmaterial mit minimaler Quellung und dem Substratmaterial mit der maximalen Quellung (der Ort der maximalen Quellung ist in der Figur 6 mit dem Bezugszeichen 15 gekennzeichnet) bestimmen zu können, wird das Kunststoffsubstrat-Beschichtungs-System 1,4, 12 nach Aufbringen des Ritzes 6 in eine entsprechend feuchte Atmosphäre gelegt, z.B. in ein Klima mit erhöhter Temperatur, z.B. 40°C, und erhöhter relativer Feuchte, z.B. 90%, so dass ein Quellen stattfinden kann (Schritt e)). Vor dem Aussetzen des Kunststoffsubstrat-Beschichtungs-Systems 1, 4, 12 des feuchtwarmen Klimas findet mit dem Interferometer eine erste Messung, der sogenannten Grundlinie, statt, von der aus dann die Veränderungen der Oberfläche erfasst werden können. Dieser Schritt ist in der allgemeinen Erfindungsbeschreibung mit dem Buchstaben d) gekennzeichnet.

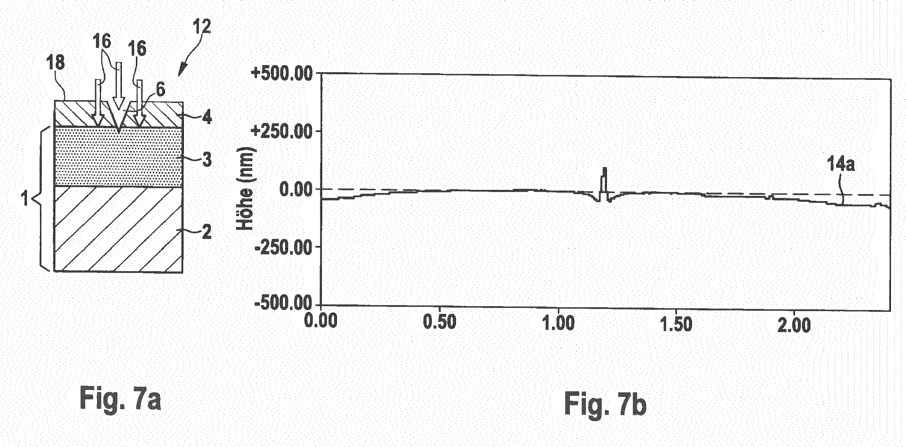

Der Brillenglasrohling 12 wird nun für eine bestimmte Zeit, die dem Quellverhalten des Kunststoffes 2 angepasst ist, in das feuchtwarme Klima gelegt und danach sofort mit dem Interferometer vermessen. Die feuchtwarme klimatische Exposition 16 des Brillenglasrohlings 12 mit dem Ritz 6 ist in der Figur 7a) skizzenhaft dargestellt. Die Figur 7b) zeigt das Höhenprofil 14a der Oberfläche des Brillenglasrohlings 12 nach der Exposition für den Fall, dass die Beschichtung 4 praktisch keine Barrierewirkung für eindringende Feuchtigkeit zeigt, was in der Figur 7a) durch gleich lange Pfeile 16 im Bereich des Ritzes 6 und der unzerstörten Oberfläche 18 der Beschichtung 4 angedeutet ist.

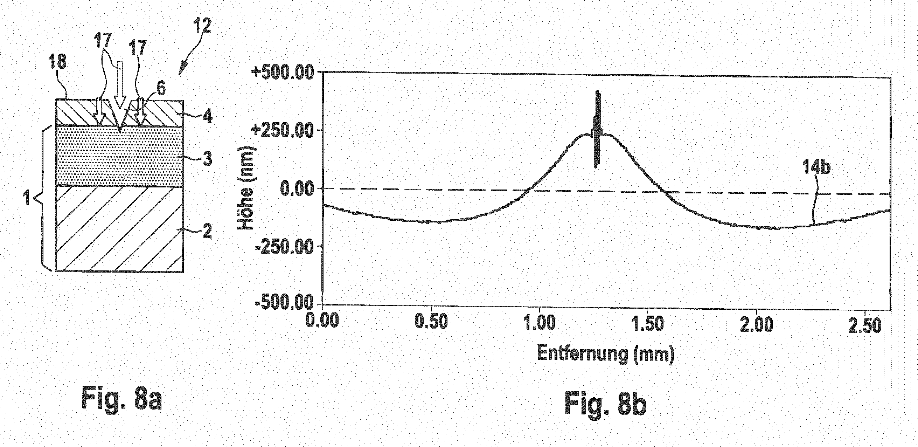

Eine feuchtwarme klimatische Exposition 17 eines Brillenglasrohlings 12 mit Ritz 6 in seiner eine gewisse Barrierewirkung aufweisenden Beschichtung 4 ist in der Figur 8a) skizzenhaft dargestellt. Die Barrierewirkung der Beschichtung 4 ist durch verkürzte Pfeile 17 im Bereich der jungfräulichen Beschichtung 4 hervorgehoben. Die Figur 8b) zeigt das Höhenprofil 14b der Oberfläche des Brillenglasrohlings 12 nach der Exposition gegenüber Feuchtigkeit.

Nach der ersten Messung wird der Brillenglasrohling 12 optional wieder für eine definierte Zeit in das feuchtwarme Klima gelegt und danach eine weitere Messung gestartet. Die Messreihe wird bevorzugt bis zu dem Zeitpunkt weitergeführt, bis nahezu keine Änderung an dem Quellverhalten mehr festgestellt wird. Erfasst wird also das zeitlich ablaufende Quellverhalten, mit dem auf das Barriereverhalten der Beschichtung 4 rückgeschlossen werden kann

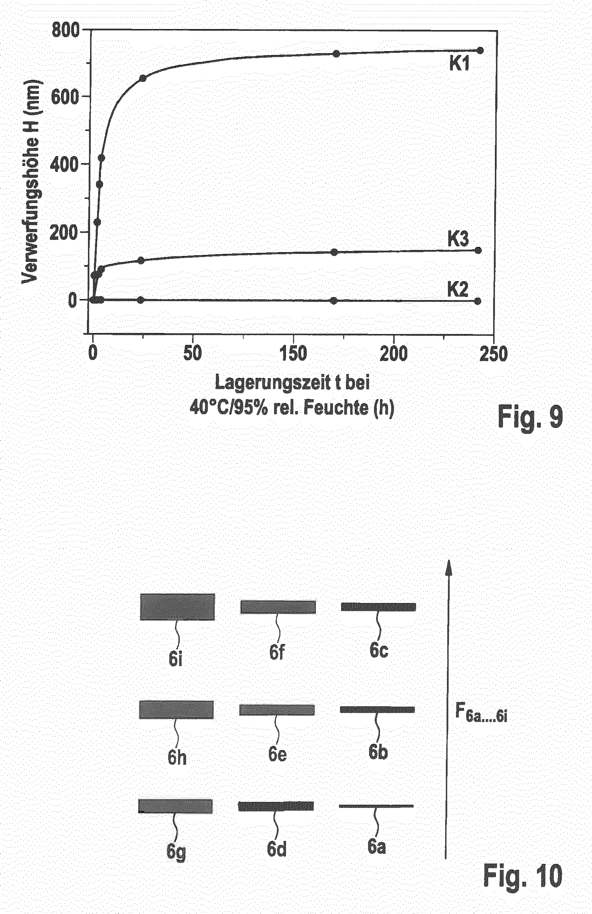

Die Figur 9 zeigt die zeitliche Abhängigkeit der Verwerfungshöhe H in Abhängigkeit von der Lagerungszeit in feuchtwarmem Klima bei 40 °C und 95 % relativer Luftfeuchtigkeit. Die Kurve K1 zeigt den Verlauf für eine wasserundurchlässige Beschichtung 4. die Kurve K2 zeigt den Verlauf für eine Beschichtung 4, die Wasser ungehindert passieren lässt und die Kurve K3 zeigt den zeitlichen Verlauf für eine Beschichtung mit mittlerer Barrierenwirkung. Bei der Beschichtung 4, die eine vollständige Barriere gegenüber Wasser darstellt, nimmt die Verwerfungshöhe H innerhalb der ersten Stunden exponentiell zu und erreicht nach etwa 100 Stunden einen Sättigungswert von ca. 740 nm. Bei der Beschichtung 4, die keine Barriere gegenüber Wasser darstellt, kann keine Verwerfung gemessen werden. Die dritte Beschichtung 4 entsprechend K3 weist ein der eine vollständige Barriere darstellenden Beschichtung 4 ähnliches zeitliches Verwerfungsverhalten auf. Der Sättigungswert der Verwerfungshöhe H liegt jedoch bei etwa 120 nm.

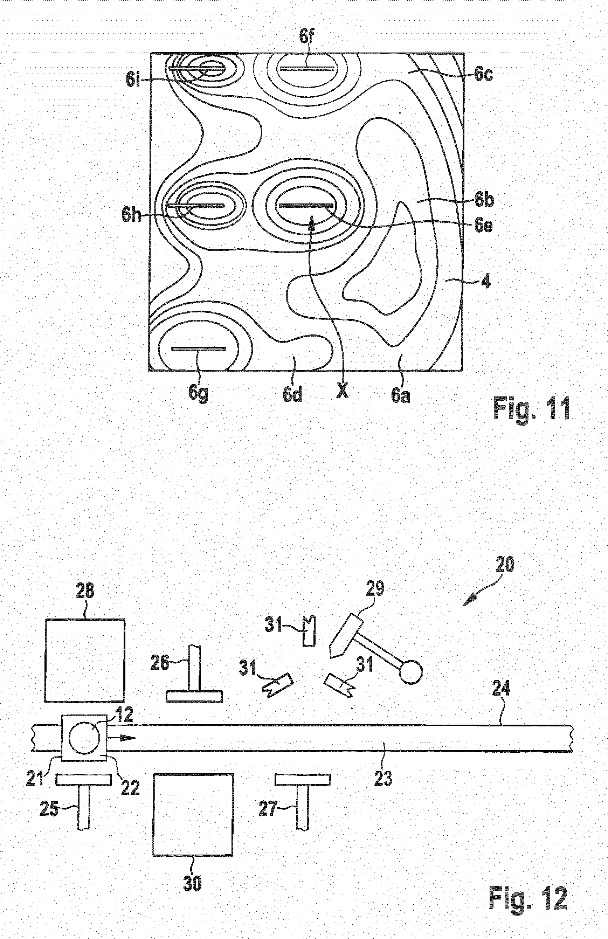

In einem weiteren optionalen Schritt werden auf das Substrat-Schicht-System 1,4, 12 eine Reihe oder eine Matrix von Ritzen 6a, 6b, 6c ... (Figur 10) mit unterschiedlichen Lasten F_{6a,} F_{66,} F_{6c ...} aufgebracht. Die Lasten F_{6a,} F_{66,} F_{6c ...} der einzelnen Ritze 6a, 6b, 6c ... starten bei einer Last F_{6a,} bei der die Beschichtung 4 nicht zerstört wird und endet bei der Last F₆ᵢ, mit der die Beschichtung 4 sicher zerstört wird. Die Lasten F_{66,} F_{6c,} F_{6d ...} F₆ₕ dazwischen werden so gewählt, dass ab einer bestimmten Last F₆ₑ der Beschichtung ein Riss 6e zugefügt wird. Anders ausgedrückt wird die Beschichtung 4 so mit einer Last F₆ₑ beaufschlagt, dass die Durchbiegung zu einem Schichtriss führt. Anschließend wird das Substrat-Beschichtungs-System 1, 4, 12, wie zuvor beschrieben, wieder in das besagte feuchtwarme Klima gelegt und nach einer definierten Zeit mittels Interferometer vermessen. Die Figur 11 zeigt ein mit einem Interferometer aufgenommenes zweidimensionales Höhenprofil des Ausschnitts nach der Figur 10 nach erfolgter Exposition des Substrats einem feuchtwarmen Klima bei 40 °C und 95 % relativer Luftfeuchtigkeit.

Ab einer bestimmten Last F₆ₑ, bei der die Beschichtung 4 erstmalig bricht, kann dann ein Aufquellen stattfinden. Der Ritz 6e, der unter Bruchlast eingebracht worden ist, ist in der Figur 11 mit dem Bezugszeichen X kenntlich gemacht. Mit dieser Methode kann eine Aussage über das Bruchlastverhalten der Beschichtung getroffen werden.

### Die gefundenen Resultate lassen sich wie folgt erklären:

Der Ritz, der auf dem Substrat-Beschichtung-System 1,4, 12 aufgebracht wird, dient als Eintrittspforte für Feuchtigkeit, die das Substrat 1 aufnehmen kann (Figuren 3 und 4). Die Möglichkeit, dass das Substrat 1 Feuchtigkeit aufnehmen kann, wird dadurch geschaffen, dass vor der Beladung mit Feuchtigkeit das Substrat 1 eine hinreichend lange Zeit in einem definiert trockenen Klima lagert (Konditionierungsschritt b)).

Wird nun das Substrat 1 mit Feuchtigkeit durch den Ritz hindurch beladen und weist die Beschichtung 4 eine Barriere für Feuchtigkeit auf, so quillt in der nahen Umgebung des Ritzes 6 der Kunststoff 2 auf ein bestimmtes Niveau an, was dann mit dem Interferometer als Höhenlinienprofil (Fig. 5) bzw. als Schnitt durch dieses Höhenlinienprofil (Fig. 6) gemessen werden kann.

Ist nun die Beschichtung 4, die sich auf dem Substrat 1 befindet, gegenüber der Feuchtigkeit barrierefrei, d.h. kann durch diese die Feuchtigkeit ungehindert hindurch, so quillt das Substrat 1 an allen Punkten gleichmäßig (Fig. 7b)). Als Resultat kann mit dem Interferometer kein Höhenunterschied zwischen dem Ritz 6 und der Umgebung gemessen werden.

Stellt die Beschichtung 4 eine Barriere für Feuchtigkeit dar, so dringt an der Stelle des Ritzes 6 mehr Feuchtigkeit in das Substrat 1 ein mit dem Resultat, dass an der Stelle des Ritzes 6 eine deutliche Erhöhung gemessen werden kann (Fig. 8b)).

### Somit gibt es drei verschiedene Möglichkeiten:

Bei einer totalen Barriere der Beschichtung gegenüber dem Medium (Wasser) ergibt sich eine maximale Verwerfungshöhe H (Kurve K1 in Fig. 9). Ohne Barriere, d.h. die Beschichtung 4 lässt das Medium ungehindert passieren, kann keine Verwerfung gemessen werden (Kurve K2 in Fig. 9). Bei einer mittleren Barriere ergibt sich eine Kurve K3, die zwischen diesen beiden Kurven K1 und K2 liegt.

Die Messung des Quellverhaltens über der Zeit t entsprechend Fig. 9 und die Lastempfindlichkeit, wie sie z.B. in Fig. 11 dargestellt ist, geben Auskunft über die Quellgeschwindigkeit, über die Stärke der Barrierewirkung der Beschichtung 4 für das Medium Feuchtigkeit, über die Empfindlichkeit des Substrat-Beschichtungs-Systems 1,4, 12 gegenüber dem Medium Feuchtigkeit und erlauben damit Aussagen zu treffen, die einem realen Verhalten in der täglichen Anwendung entsprechen (wie z.B. bei Brillengläsern).

Die Figur 12 zeigt abschließend ein Ausführungsbeispiel für eine erfindungsgemäße Vorrichtung 20 zur Bestimmung einer Barrierewirkung einer Beschichtung 4 auf einem Brillenglasrohling 12. Die Vorrichtung 20 umfasst eine Substratbereitstellungseinrichtung in Form eines Schlittens 21 mit einer Auflagefläche 22. Der Schlitten 21 befindet sich auf einer Transporteinrichtung 23 in Form eines Förderbands 24 mit einer Mehrzahl an Schiebern 25, 26, 27, um den Schlitten 21 von dem Förderband 24 unterschiedlichen Behandlungs- und Messeinrichtungen zuführen zu können und von dort wieder zurück auf das Förderband 24 zurückzubewegen. Zu den unterschiedlichen Behandlungs- und Messeinrichtungen zählen eine Konditioniereinrichtung in Form einer Klimakammer 28, ein Diamantritzwerkzeug 29 sowie ein Interferometer 30.

Die Vorrichtung 20 umfasst ferner eine in der Figur 12 nicht dargestellte elektronische Steuereinrichtung, um die Transporteinrichtung 24 und die Funktionalität der übrigen Komponenten, nämlich der Klimakammer 28, des Diamantritzwerkzeugs 29 sowie des Interferometers 30 zu steuern.

### Die Vorrichtung 20 kann in der nachfolgend beschriebenen Weise betrieben werden:

In einem Schritt a) wird ein Brillenglasrohling 12 auf der Auflagefläche 22 des Schlittens 21 bereitgestellt. Der Brillenglasrohling 12 umfasst ein mit einer Beschichtung 4 versehenes Substrat 1, welches bei Kontakt mit Wasser oder Wasserdampf sein Volumen verändert.

Der Schieber 25 schiebt den Brillenglasrohling 12 in die Klimakammer 28. In der Klimakammer 28 erfolgt entsprechend dem erfindungsgemäßen Verfahrensschritt b) ein Konditionieren des Brillenglasrohlings 12 in der eingangs beschriebenen Weise durch Exposition einem Normklima von 23 °C und 50 % relativer Luftfeuchtigkeit für 72 Stunden.

Nach dieser Zeit wird der Brillenglasrohling 12 mittels des Schiebers 25 wieder auf die Transporteinrichtung 23 zurück befördert. Der Schlitten 21 wird dann bis zum Schieber 27 verfahren. Der Schieber 27 verschiebt den Schlitten 21 unter das Diamantritzwerkzeug 29. Der Brillenglasrohling 12 wird an dessen Seitenrand mittels eines Dreipunktgreifers 31 fixiert. Dann erfolgt entsprechend dem erfindungsgemäßen Schritt c) ein Entfernen der Beschichtung 4 von einer ersten Teiloberfläche des Substrats 1.

Der Dreipunktgreifer 31 setzt daraufhin den Brillenglasrohling 12 wieder auf der Auflagefläche 22 des Schlittens 21 ab und der Schieber 27 verbringt den Schlitten 21 wieder auf das Förderband 24.

Das Förderband 24 transportiert den Schlitten 21 mit dem Brillenglasrohling 12 bis zum Schieber 26, der den Schlitten 21 zum Bestimmen eines ersten Höhenprofils in das Interferometer 30 verbringt (Schritt d)).

Nachfolgend wird der Brillenglasrohling 12 in der vorstehend beschriebenen Weise wieder in die Klimakammer 28 transportiert. Der Brillenglasrohling 12 wird einem feuchtwarmen Klima von 40 °C und 90 % relativer Luftfeuchtigkeit für 10 Minuten ausgesetzt (Schritt e)).
Es erfolgt daraufhin ein Transport zum Interferometer 30 mit dessen Hilfe entsprechend Schritt f) ein zweites Höhenprofil der Oberfläche des Brillenglasrohlings 12 in der Umgebung des Ritzes 6 aufgenommen wird (Schritt f)).

Die letztgenannten Schritte e) und f) werden mehrfach durchgeführt, bis keine signifikante Änderung des gemessenen Höhenprofils mehr feststellbar ist.

Damit ist gezeigt, dass das vorstehend beschriebene Verfahren auch automatisiert durchgeführt werden kann.

## Patentansprüche

1. Verfahren zur Bestimmung einer Barrierewirkung einer Beschichtung (4) für ein Medium (16, 17) mit folgenden Schritten:
a) Bereitstellen der Beschichtung auf einer Oberfläche eines Substrats (1), welches bei Kontakt mit dem Medium (16, 17) sein Volumen verändert,
b) Konditionieren des Substrats (1) mit der Beschichtung (4),
c) Entfernen der Beschichtung (4) von einer ersten Teiloberfläche (6) des Substrats (1), wobei die Beschichtung (4) auf einer zweiten Teiloberfläche des Substrats (1) verbleibt, wobei die erste Teiloberfläche (6) eine durch die auf der zweiten Teiloberfläche verbliebene Beschichtung (4) begrenzte Ausdehnung (L) in eine erste Richtung aufweist,
d) Bestimmen eines ersten Höhenprofils einer Oberfläche der Beschichtung (4) auf der zweiten Teiloberfläche und der ersten Teiloberfläche (6) des Substrats (1) auf einem Weg längs der ersten Richtung,
e) Aussetzen der Oberfläche der verbleibenden Beschichtung (4) und der ersten Teiloberfläche (6) des Substrats (1) dem Medium (16, 17),
f) Bestimmen eines zweiten Höhenprofils der Oberfläche der Beschichtung (4) auf der zweiten Teiloberfläche und der ersten Teiloberfläche (6) des Substrats (1) auf dem Weg längs der ersten Richtung und/oder Bestimmen einer ersten Höhenprofildifferenz (H) der Oberfläche der Beschichtung (4) auf der zweiten Teiloberfläche und der ersten Teiloberfläche (6) des Substrats (1) auf dem Weg längs der ersten Richtung gegenüber dem zuvor bestimmten Höhenprofil.

2. Verfahren nach Anspruch 1, **dadurch gekennzeichnet, dass** das Entfernen der Beschichtung (4) gemäß Schritt c) mit einem Ritzwerkzeug, insbesondere einem Diamantritzwerkzeug (7, 29) durchgeführt wird, welches längs der ersten Richtung Material abtragend geführt wird.

3. Verfahren nach einem der vorangegangenen Ansprüche, **dadurch gekennzeichnet, dass** die erste Teiloberfläche (6) eine Ausdehnung (B) in eine zweite Richtung aufweist und dass die Ausdehnung (L) der ersten Teiloberfläche (6) in der ersten Richtung wenigstens zehnfach größer als die Ausdehnung (B) der ersten Teiloberfläche (6) in der zweiten Richtung ist.

4. Verfahren nach einem der vorangegangenen Ansprüche, **dadurch gekennzeichnet, dass** vor dem Bestimmen des ersten Höhenprofils gemäß Schritt d) eine nicht mit der ersten Teiloberfläche (6) des Substrats (1) identische, jedoch nicht mit der Beschichtung versehene dritte Teiloberfläche mit einer für das Medium (16, 17) undurchlässigen Barriere versehen wird.

5. Verfahren nach einem der vorangegangenen Ansprüche, **dadurch gekennzeichnet, dass** das Bestimmen des ersten Höhenprofils gemäß Schritt d) und/oder das Bestimmen des zweiten Höhenprofils und/oder der ersten Höhenprofildifferenz gemäß Schritt f) mit Hilfe eines Interferometers (30) durchgeführt wird.

6. Verfahren nach einem der vorangegangenen Ansprüche, **dadurch gekennzeichnet, dass** die Folge der Schritte e) und f) wiederholt durchgeführt wird.

7. Verfahren nach Anspruch 6, **dadurch gekennzeichnet, dass** die Folge der Schritte e) und f) wiederholt durchgeführt wird, bis ein Abbruchkriterium erfüllt ist.

8. Verfahren nach Anspruch 7, **dadurch gekennzeichnet, dass** das Abbruchkriterium in dem Fall, bei dem im Schritt f) eine erste Höhenprofildifferenz (H) ermittelt wird, darin besteht, dass die erste Höhenprofildifferenz (H) unter einem vorgegebenen Schwellwert liegt.

9. Verfahren nach einem der vorangegangenen Ansprüche, **dadurch gekennzeichnet, dass** das Entfernen der Beschichtung bei dem Schritt c) vollständig bis zur Oberfläche des Substrats (1) durchgeführt wird.

10. Verfahren nach einem der Ansprüche 1 bis 8, **dadurch gekennzeichnet, dass** die Folge der Schritte c) bis f) mehrfach örtlich nebeneinander durchgeführt wird, wobei das Entfernen der Beschichtung (4) bei den jeweiligen Schritten c) bei den örtlich nebeneinander durchgeführten Folgen in unterschiedlichem Ausmaß durchgeführt wird.

11. Verfahren nach Anspruch 10, **dadurch gekennzeichnet, dass** das Entfernen der Beschichtung in den jeweiligen Schritten c) bei den örtlich nebeneinander durchgeführten Folgen unter unterschiedlicher Last durchgeführt wird.

12. Verfahren nach einem der Ansprüche 10 oder 11, **dadurch gekennzeichnet, dass** das Entfernen der Beschichtung (4) bei einem der jeweiligen Schritte c) bei den örtlich nebeneinander durchgeführten Folgen vollständig bis zur Oberfläche des Substrats (1) durchgeführt wird.

13. Verfahren nach einem der Ansprüche 10 bis 12, **dadurch gekennzeichnet, dass** das Entfernen der Beschichtung (4) bei wenigstens einem der jeweiligen Schritte c) bei den örtlich nebeneinander durchgeführten Folgen nicht vollständig bis zur Oberfläche des Substrats (1) durchgeführt wird.

14. Vorrichtung (20) zur Bestimmung einer Barrierewirkung einer Beschichtung (4) für ein Medium (16, 17) mit folgenden Komponenten:
a) einer Bereitstellungseinrichtung (21) zum Bereitstellen der Beschichtung (4) auf einem Substrat (1), welches bei Kontakt mit dem Medium (16, 17) sein Volumen verändert,
b) einer Konditioniereinrichtung (28) zum Konditionieren des Substrats (1) mit der Beschichtung (4),
c) einer Entfernungseinrichtung (7, 29) zum Entfernen der Beschichtung (4) von einer ersten Teiloberfläche (6) des Substrats (1), so dass die Beschichtung auf einer zweiten Teiloberfläche des Substrats (1) verbleibt und so dass die erste Teiloberfläche (6) eine durch die auf der zweiten Teiloberfläche verbliebene Beschichtung (4) begrenzte Ausdehnung (L) in eine erste Richtung aufweist,
d) einer Bestimmungseinrichtung (30) zum Bestimmen eines ersten Höhenprofils einer Oberfläche der Beschichtung (4) auf der zweiten Teiloberfläche und der ersten Teiloberfläche (6) des Substrats (1) auf einem Weg längs der ersten Richtung,
e) einer Aussetzungseinrichtung (28) zum Aussetzen der Oberfläche der verbleibenden Beschichtung (4) und der ersten Teiloberfläche (6) des Substrats (1) dem Medium (16, 17)
f) einer Bestimmungseinrichtung (30) zum Bestimmen eines zweiten Höhenprofils der Oberfläche der Beschichtung (4) auf der zweiten Teiloberfläche und der ersten Teiloberfläche (6) des Substrats (1) auf dem Weg längs der ersten Richtung und/oder zum Bestimmen einer ersten Höhenprofildifferenz (H) der Oberfläche der Beschichtung (4) auf der zweiten Teiloberfläche und der ersten Teiloberfläche (6) des Substrats (1) auf dem Weg längs der ersten Richtung gegenüber dem zuvor bestimmten Höhenprofil.

15. Computerprogramm mit Programmcode zur Durchführung aller Verfahrensschritte nach einem der Ansprüche 1 bis 13 in einer Vorrichtung nach Anspruch 14, wenn das Computerprogramm in einem Computer geladen und/oder in einem Computer ausgeführt wird, welcher die Vorrichtung steuert.

## Claims

1. Method for determining a barrier effect of a coating (4) for a medium (16, 17) comprising the following steps:
a) provision of the coating on a surface of a substrate (1), which on contact with the medium (16, 17) undergoes a change in volume,
b) conditioning of the substrate (1) with the coating (4),
c) removal of the coating (4) from a first part of the surface (6) of the substrate (1), with the coating (4) remaining on a second part of the surface of the substrate (1), and with the first part of the surface (6) having an extension (L) in a first direction delimited by the coating (4) remaining on the second part of the surface,
d) determination of a first height profile of a surface of the coating (4) on the second part of the surface and the first part of the surface (6) of the substrate (1) on a path in the first direction,
e) exposure of the surface of the remaining coating (4) and the first part of the surface (6) of the substrate (1) to the medium (16, 17),
f) determination of a second height profile of the surface of the coating (4) on the second part of the surface and the first part of the surface (6) of the substrate (1) on the path in the first direction and/or determination of a first height profile difference (H) of the surface of the coating (4) on the second part of the surface and the first part of the surface (6) of the substrate (1) on the path in the first direction with respect to the previously-determined height profile.

2. Method according to Claim 1, **characterized in that** removal of the coating (4) according to step c) is carried out using a scratching tool, in particular a diamond scratching tool (7, 29), which is guided in the first direction to remove material.

3. Method according to one of the preceding claims, **characterized in that** the first part of the surface (6) has an extension (B) in a second direction and **in that** the extension (L) of the first part of the surface (6) in the first direction is at least ten times greater than the extension (B) of the first part of the surface (6) in the second direction.

4. Method according to one of the preceding claims, **characterized in that** prior to determination of the first height profile according to step d), a third part of the surface that is not identical to the first part of the surface (6) of the substrate (1) but does not have the coating is provided with a barrier that is impermeable to the medium (16, 17).

5. Method according to one of the preceding claims, **characterized in that** determination of the first height profile according to step d) and/or determination of the second height profile and/or the first height profile difference according to step f) is carried out using an interferometer (30).

6. Method according to one of the preceding claims, **characterized in that** the series of steps e) and f) is carried out repeatedly.

7. Method according to Claim 6, **characterized in that** the series of steps e) and f) is carried out repeatedly until a termination criterion is fulfilled.

8. Method according to Claim 7, **characterized in that** the termination criterion for cases in which a first height profile difference (H) is determined in step f) is that the first height profile difference (H) must be below a specified threshold value.

9. Method according to one of the preceding claims, **characterized in that** removal of the coating in step c) is carried out completely down to the surface of the substrate (1).

10. Method according to one of Claims 1 to 8, **characterized in that** the series of steps c) through f) is repeatedly carried out locally in parallel, wherein removal of the coating (4) in the respective steps c) in the series carried out locally in parallel is carried out to differing degrees.

11. Method according to Claim 10, **characterized in that** removal of the coating in the respective steps c) in the series carried out locally in parallel is carried out under differing loads.

12. Method according to one of Claims 10 or 11, **characterized in that** removal of the coating (4) in one of the respective steps c) in the series carried out locally in parallel is carried out all the way to the surface of the substrate (1).

13. Method according to one of Claims 10 to 12, **characterized in that** removal of the coating (4) in at least one of the respective steps c) in the series carried out locally in parallel is not carried out all the way to the surface of the substrate (1).

14. Device (20) for determining a barrier effect of a coating (4) for a medium (16, 17) having the following components:
a) a provision device (21) for provision of the coating (4) on a substrate (1), which on contact with the medium (16, 17) undergoes a change in volume,
b) a conditioning device (28) for conditioning of the substrate (1) with the coating (4),
c) a removal device (7, 29) for removal of the coating (4) from a first part of the surface (6) of the substrate (1), so that the coating remains on a second part of the surface of the substrate (1) and so that the first part of the surface (6) has an extension (L) in a first direction delimited by the coating (4) remaining on the second part of the surface,
d) a determination device (30) for determination of a first height profile of a surface of the coating (4) on the second part of the surface and the first part of the surface (6) of the substrate (1) on a path in the first direction,
e) an exposure device (28) for exposure of the surface of the remaining coating (4) and the first part of the surface (6) of the substrate (1) to the medium (16, 17),
f) a determination device (30) for determination of a second height profile of the surface of the coating (4) on the second part of the surface and the first part of the surface (6) of the substrate (1) on the path in the first direction and/or for determination of a first height profile difference (H) of the surface of the coating (4) on the second part of the surface and the first part of the surface (6) of the substrate (1) on the path in the first direction with respect to the previously-determined height profile.

15. Computer program with program code for carrying out all of the process steps according to one of Claims 1 to 13 in a device according to Claim 14, when the computer program is loaded onto a computer and/or run on a computer that controls the device.

## Revendications

1. Procédé de détermination de l'effet de barrière d'un revêtement (4) vis-à-vis d'un fluide (16, 17), le procédé comportant les étapes suivantes :
a) application du revêtement sur une surface d'un substrat (1) dont le volume se modifie au contact du fluide (16, 17),
b) conditionnement du substrat (1) avec le revêtement (4),
c) enlèvement du revêtement (4) d'une première partie (6) de la surface du substrat (1), le revêtement (4) restant sur une deuxième partie de la surface du substrat (1), la première partie (6) de la surface présentant dans une première direction une extension (L) limitée par le revêtement (4) qui reste sur la deuxième partie de la surface,
d) détermination d'un premier profil de hauteur d'une surface du revêtement (4) sur la deuxième partie de surface et la première partie (6) de la surface du substrat (1) sur un parcours qui suit la première direction,
e) exposition de la surface du reste du revêtement (4) et de la première partie (6) de la surface du substrat (1) au fluide (16, 17),
f) détermination d'un deuxième profil de hauteur de la surface du revêtement (4) sur la deuxième partie de la surface et la première partie (6) de la surface du substrat (1) sur le parcours qui longe la première direction et/ou détermination d'une première différence (H) du profil de hauteur de la surface du revêtement (4) sur la deuxième partie de la surface et la première partie (6) de la surface du substrat (1) sur le parcours qui longe la première direction par rapport au profil de hauteur déterminé précédemment.

2. Procédé selon la revendication 1, **caractérisé en ce que** l'enlèvement du revêtement (4) à l'étape c) est réalisé à l'aide d'un outil à rayer, en particulier un outil à rayer (7, 29) au diamant qui est guidé le long de la première direction de manière à arracher de la matière.

3. Procédé selon l'une des revendications précédentes, **caractérisé en ce que** la première partie (6) de la surface présente une extension (B) dans une deuxième direction et **en ce que** l'extension (L) de la première partie (6) de la surface dans la première direction est au moins dix fois plus grande que l'extension (B) de la première partie (6) de la surface dans la deuxième direction.

4. Procédé selon l'une des revendications précédentes, **caractérisé en ce qu'**avant la détermination du premier profil de hauteur à l'étape d), une troisième partie de surface, non identique à la première partie (6) de la surface du substrat (1) mais non dotée du revêtement, est dotée d'une barrière imperméable au fluide (16, 17).

5. Procédé selon l'une des revendications précédentes, **caractérisé en ce que** la détermination du premier profil de hauteur à l'étape d) et/ou la détermination du deuxième profil de hauteur et/ou de la première différence de profil de hauteur à l'étape f) s'effectue à l'aide d'un interféromètre (30).

6. Procédé selon l'une des revendications précédentes, **caractérisé en ce que** la succession des étapes e) et f) est réalisée de manière répétée.

7. Procédé selon la revendication 6, **caractérisé en ce que** la succession des étapes e) et f) est réalisée de manière répétée jusqu'à ce qu'un critère d'interruption soit satisfait.

8. Procédé selon la revendication 7, **caractérisé en ce qu'**au cas où à l'étape f) une première différence (H) du profil de hauteur est déterminée, le critère d'interruption et que la première différence (H) du profil de hauteur est située en dessous d'une valeur de seuil prédéterminée.

9. Procédé selon l'une des revendications précédentes, **caractérisé en ce que** l'enlèvement du revêtement à l'étape c) est réalisé entièrement jusqu'à la surface du substrat (1).

10. Procédé selon l'une des revendications 1 à 8, **caractérisé en ce que** la succession des étapes c) à f) est réalisée plusieurs fois en des emplacements situés les uns à côté des autres, l'enlèvement du revêtement (4) lors des étapes c) étant réalisé dans des mesures différentes lors des opérations réalisées en des emplacements situés à côté les uns des autres.

11. Procédé selon la revendication 10, **caractérisé en ce que** l'enlèvement du revêtement au cours des étapes c) est réalisé lors des opérations locales adjacentes sous des charges différentes.

12. Procédé selon l'une des revendications 10 ou 11, **caractérisé en ce que** l'enlèvement du revêtement (4) lors de l'étape c) lors des opérations réalisées en des emplacements adjacents est réalisé complètement jusqu'à la surface du substrat (1).

13. Procédé selon l'une des revendications 10 à 12, **caractérisé en ce que** l'enlèvement du revêtement (4) lors d'au moins l'une des opérations réalisées en des emplacements adjacents n'est pas réalisé complètement jusqu'à la surface du substrat (1).

14. Ensemble (20) de détermination de l'effet de barrière d'un revêtement (4) vis-à-vis d'un fluide (16, 17), l'ensemble comportant les composants suivants :
a) un dispositif de préparation (21) qui prépare le revêtement (4) sur un substrat (1) dont le volume se modifie au contact du fluide (16, 17),
b) un dispositif de conditionnement (28) qui conditionne le substrat (1) doté du revêtement (4),
c) un dispositif d'enlèvement (7, 29) qui enlève le revêtement (4) d'une première partie (6) de la surface du substrat (1) de telle sorte que le revêtement reste sur une deuxième partie de la surface du substrat (1) et qu'ainsi la première partie (6) de la surface présente dans une première direction une extension (L) limitée par le revêtement (4) qui reste sur la deuxième partie de la surface,
d) un dispositif de détermination (30) qui détermine un premier profil de hauteur de la surface du revêtement (4) sur la deuxième partie de la surface et la première partie (6) de la surface du substrat (1) sur un parcours qui longe la première direction,
e) un dispositif d'exposition (28) qui expose la surface du revêtement (4) qui reste et la première partie (6) de la surface du substrat (1) au fluide (16, 17),
f) un dispositif de détermination (30) qui détermine un deuxième profil de hauteur de la surface du revêtement (4) sur la deuxième partie de la surface et la première partie (6) de la surface du substrat (1) sur le parcours qui longe la première direction et/ou qui détermine une première différence (H) de profil de hauteur de la surface du revêtement (4) sur la deuxième partie de la surface et la première partie (6) de la surface du substrat (1) sur le parcours qui longe la première direction, par rapport au profil de hauteur déterminé précédemment.

15. Programme informatique doté de codes de programme permettant de mettre en oeuvre toutes les étapes du procédé selon l'une des revendications 1 à 13 dans un dispositif selon la revendication 14 lorsque le programme informatique est chargé sur un ordinateur et/ou est exécuté sur un ordinateur qui commande l'ensemble.
